(19) Europäisches Patentamt
European Patent Office
Office européen des brevets

(11) **EP 2 572 208 B1**

(12) **EUROPÄISCHE PATENTSCHRIFT**

(45) Veröffentlichungstag und Bekanntmachung des Hinweises auf die Patenterteilung:
**29.11.2017 Patentblatt 2017/48**

(21) Anmeldenummer: **11723395.7**

(22) Anmeldetag: **19.05.2011**

(51) Int Cl.:
*G01R 31/36* (2006.01)   *H01M 10/44* (2006.01)
*H01M 10/48* (2006.01)   *H02J 7/00* (2006.01)
*H02J 7/35* (2006.01)

(86) Internationale Anmeldenummer:
**PCT/EP2011/058138**

(87) Internationale Veröffentlichungsnummer:
**WO 2011/144695 (24.11.2011 Gazette 2011/47)**

(54) **ANORDNUNG ZUR EINZELZELLENMESSUNG IN EINEM AKKUPACK UND EINEM AKKUPACK MIT EINER SOLCHEN ANORDNUNG**

ARRANGEMENT FOR MEASURING A SINGLE CELL IN A RECHARGEABLE BATTERY PACK AND RECHARGEABLE BATTERY PACK COMPRISING SUCH AN ARRANGEMENT

DISPOSITIF DE MESURE DES DIFFÉRENTES ÉLÉMENTS D'UNE BATTERIE D'ACCUMULATEURS ET BATTERIE D'ACCUMULATEURS DOTÉ D'UN TEL DISPOSITIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.05.2010 DE 102010021176**

(43) Veröffentlichungstag der Anmeldung:
**27.03.2013 Patentblatt 2013/13**

(73) Patentinhaber: **Metabowerke GmbH**
**72622 Nürtingen (DE)**

(72) Erfinder:
• **WIESNER, Bernd**
**73277 Owen (DE)**

• **BECK, Tobias**
**72639 Neuffen (DE)**

(74) Vertreter: **Lorenz, Markus**
**Lorenz & Kollegen**
**Patentanwälte Partnerschaftsgesellschaft mbB**
**Alte Ulmer Straße 2**
**89522 Heidenheim (DE)**

(56) Entgegenhaltungen:
**EP-A2- 1 289 096      DE-T2- 69 837 661**
**JP-A- 2010 008 227    US-A- 5 543 245**
**US-B1- 6 169 385**

**Beschreibung**

Die Erfindung betrifft eine Anordnung zur Einzelzellenmessung in einem Akkupack, wobei der Akkupack eine Serienschaltung aus mehreren Zellen umfasst, wobei zwei benachbarte Zellen mittels eines Verbindungszweigs elektrisch miteinander verbunden sind, und wobei die Anordnung eine Messeinrichtung aufweist und eine Schalteinrichtung umfasst, die zum wahlweisen Verbinden genau eines Verbindungszweigs mit einem Messeingang der Messeinrichtung eingerichtet ist. Die Erfindung betrifft außerdem einen Akkupack, der eine solche Anordnung aufweist.

Eine Anordnung zur Einzelzellenmessung, mit einer Schalteinrichtung und einer Messeinrichtung ist allgemein bekannt. Bei dieser Anordnung ist die Messeinrichtung zum Messen eines Potenzials bezogen auf einen Minus-Pol einer Serienschaltung von Zellen eingerichtet. Während eines Messzyklus verbindet die Schalteinrichtung nacheinander Plus-Pole der einzelnen Zellen des Akkupacks mit einem Messeingang der Messeinrichtung. Auf diese Weise kann das Potenzial an dem Plus-Pol der einzelnen Zellen nacheinander erfasst werden.

Bei jeder Messung des Potenzials an einem bestimmten Plus-Pol, wird eine bestimmte Teilmenge der Zellen des Akkupacks mit einem gewissen Messstrom belastet. Bei der bekannten Anordnung variiert der mittlere Messstrom von Zelle zu Zelle. Innerhalb eines Messzyklus, bei dem das Potenzial an dem Plus-Pol einer jeden Zelle erfasst wird, wird jeder Zelle eine unterschiedliche elektrische Ladung entnommen. Im Laufe der Zeit werden hierdurch die einzelnen Zellen in Folge der Messzyklen unterschiedlich stark entladen, was zu einer Debalanzierung des Ladezustands der einzelnen Zellen führen kann. Dies hat zur Folge, insbesondere in dem Fall, dass der Akkupack längere Zeit weder durch eine Nutzlast wie beispielsweise durch einen Elektromotor eines Elektrogeräts entladen oder über eine Ladeschaltung geladen wird, dass aufgrund der Debalanzierung des Ladezustands der einzelnen Zelle infolge der Überwachung ein gesonderter Ladevorgang erforderlich wird, um die Ladezustände der einzelnen Zellen wieder aneinander anzugleichen. Dies führt wiederum zu einer höhere Anzahl von Ladezyklen und somit zu einem höheren Verschleiß der einzelnen Zellen des Akkupacks.

Nachfolgend wird auf einige Schriften verwiesen, die den Stand der Technik und somit den Hintergrund zu der vorliegenden Erfindung umreißen.

Die EP 1 289 096 A2 betrifft eine Vorrichtung zum Akkuzellenmanagement für Hochleistungsakkus, die zu einer Serienschaltung verbunden sind.

Die DE 698 37 661 T2 offenbart ein System und ein Verfahren zur Verwaltung eines als eine Reserve für eine Wechselstromquelle genutzten Batteriesatzes, insbesondere für verteilte Telekommunikationssysteme.

Die US 6 169 385 B1 bezieht sich auf eine Schaltung zur Kapazitätsanpassung von Einzelzellen einer in Reihe zusammengeschalteten Gruppe von Akkuzellen. Schließlich zeigt die JP 2010 00 8227 A eine Vorrichtung, die es ermöglicht, die Spannung eines Akkupacks mit einfachen Mitteln zu erfassen, ohne den Stromverbrauch aufgrund von Leckströmen zu erhöhen.

Der vorliegenden Erfindung liegt somit die Aufgabe zugrunde, eine Anordnung zur Einzelzellenmessung beziehungsweise einen Akkupack, in den eine solchen Anordnung integriert ist, anzugeben, bei dem die Debalanzierung des Ladezustands der einzelnen Zellen infolge der Messungen mittels der Messeinrichtung zumindest weitgehend vermieden wird.

Diese Aufgabe wird durch eine Anordnung zur Zellenmessung entsprechend der Merkmale des unabhängigen Anspruchs 1 gelöst, wobei ein äußerer Pol der Serienschaltung einen Bezugspunkt bildet, und wobei zumindest diejenigen Zellen, die mittelbar mit dem Bezugspunkt verbunden sind, jeweils mindestens eine parallel geschaltete Last aufweisen, und wobei die Last mittels eines Steuersignals wahlweise in einen aktivierten Betriebszustand oder in einen deaktivierten Betriebszustand gebracht werden kann, sodass mindestens einer Zelle während des aktivierten Betriebszustands mittels der Last elektrische Ladung entnehmbar ist.

Hierbei kann vorgesehen werden, dass die Anordnung eine Steuereinrichtung aufweist, die zum Erzeugen des Steuersignals zum Aktivieren und Deaktivieren mindestens einer Last eingerichtet ist, sodass bei aufeinanderfolgendem Verbinden verschiedener Verbindungszweige mit dem Messeingang ein ungleichmäßiges Entladen der Zellen infolge eines Messstroms am Messeingang zumindest weitgehend vermieden wird. Die Steuereinrichtung kann beispielsweise einen Mikrokontroller mit mindestens einem Digitalausgang aufweisen, wobei der Digitalausgang mit einem Ansteuereingang der Last verbunden ist.

Es ist besonders bevorzugt, dass die mindestens eine Last zu genau einer Zelle parallel geschaltet ist. Die Last kann also an zwei benachbarte Verbindungszweige angeschlossen sein, wobei die beiden benachbarten Verbindungszweige jeweils mit den Pluspol und den Minuspol derselben Zelle verbunden sind.

Um einen einfachen Aufbau der Anordnung zu erreichen, ist bevorzugt, dass die Messeinrichtung zum Erfassen einer Spannung zwischen dem Messeingang und einem Bezugspunkt innerhalb der Serienschaltung eingerichtet ist, wobei der Bezugspunkt mit einem Anschluss der Messeinrichtung elektrisch verbunden ist.

Weiter ist bevorzugt, dass alle Zellen des Akkupacks zu der Serienschaltung gehören und/oder ein äußeres Ende der Serienschaltung, vorzugsweise ein Minus-Pol einer äußeren Zelle der Serienschaltung, den Bezugspunkt bilden. Bei dem Bezugspunkt kann es sich also beispielsweise um eine Masseleitung der Anordnung handeln. Die Masseleitung kann mit dem Minus-Pol derjenigen Zelle der Serienschaltung verbunden sein, deren Minus-Pol nicht mit einer anderen Zelle verbunden ist. Hierdurch wird erreicht, dass das Massepotential das niedrigste Potential innerhalb der Serienschaltung ist und die Messeinrichtung im Normalfall lediglich positive Potentiale gegenüber dem Massepotential erfassen muss.

Um den Schaltungsaufwand für die Anordnung zu reduzieren, kann vorgesehen werden, dass ausschließlich denjenigen Zellen, die mittelbar mit dem Bezugspunkt verbunden sind je eine Last zugeordnet ist. In anderen Worten ist derjenigen Zelle, deren Minus-Pol oder Plus-Pol direkt mit dem Bezugspunkt, beispielsweise der Masseleitung, verbunden ist keine Last zugeordnet.

Es ist bevorzugt, dass die Last mindestens ein Schaltelement aufweist, das bei aktivierter Last geschlossen und bei deaktivierter Last geöffnet ist, wobei eines dieser Schaltelemente zugleich ein Schaltelement der Schalteinrichtung bildet. Bei dem mindestens einen Schaltelement kann es sich um einen Halbleiterschalter, vorzugsweise um einen Biopolartransistor oder einen Unipolartransistor, handeln. Dadurch, dass eines der Schaltelemente zugleich dem Aktivieren und Deaktivieren der Last und dem Verbinden eines bestimmten Verbindungszweigs mit dem Messeingang dient, wird die Anzahl der Bauteile, insbesondere der Transistoren, die zum Aufbau der Anordnung zur Zellenmessung benötigt werden, gering gehalten.

Die Last wird realisiert, indem die Last eine Serienschaltung umfassend einen Halbleiterschalter, wie beispielsweise einen Transistor, und einen Widerstand aufweist. Bei dem Widerstand kann es sich um einen einstellbaren Widerstand oder einen Festwiderstand handeln.

Hierbei kann vorgesehen werden, dass die Serienschaltung zusätzlich eine Halbleiterdiode aufweist, die dem Widerstand vorgeschaltet oder nachgeschaltet ist.

Es ist vorgesehen, den Wert des Widerstandes jeweils so zu bemessen, dass in einem Messzyklus jeder Zelle im Wesentlichen dieselbe Ladung entnommen wird.

Als weitere Lösung der oben angegebenen Aufgabe wird ein Akkupack mit einer Anordnung zur Einzelzellenmessung vorgeschlagen, wobei der Akkupack eine Serienschaltung aus mehreren Zellen umfasst, wobei zwei benachbarte Zellen jeweils mittels eines Verbindungszweigs elektrisch miteinander verbunden sind, wobei ein äußerer Pol der Serienschaltung einen Bezugspunkt bildet, und wobei die Anordnung eine Messeinrichtung aufweist und eine Schalteinrichtung umfasst, die zum wahlweisen Verbinden genau eines Verbindungszweigs mit einem Messeingang der Messeinrichtung eingerichtet ist. Dabei weisen zumindest diejenigen Zellen, die mittelbar mit dem Bezugspunkt verbunden sind jeweils mindestens eine parallel geschaltete Last auf, wobei die Last mittels eines Steuersignals wahlweise in einen aktivierten Betriebszustand oder in einen deaktivierten Betriebszustand gebracht werden kann, sodass mindestens einer Zelle während des aktivierten Betriebszustands mittels der Last elektrische Ladung entnehmbar ist, wobei die Last eine Serienschaltung umfassend einen Halbleiterschalter und einen Widerstand aufweist und wobei der Wert des Widerstandes jeweils so bemessen ist, dass in einem Messzyklus jeder Zelle im Wesentlichen dieselbe Ladung entnommen wird.

Es ist bevorzugt, dass die Anordnung zur Einzelzellmessung des Akkupacks als eine erfindungsgemäße Anordnung nach einem der Ansprüche 1 bis 8 ausgebildet ist. Hierdurch können die Vorteile der erfindungsgemäßen Anordnung zur Einzelzellmessung auch beim erfindungsgemäßen Akkupack realisiert werden.

Weitere Merkmale und Vorteile der Erfindung ergeben sich aus der nachfolgenden Beschreibung, in welcher exemplarische Ausführungsformen der Erfindung anhand der Zeichnungen näher erläutert werden. Dabei zeigen:

Figur 1 Ein Prinzipschaltbild eines Elektrogeräts mit einer Anordnung zur Einzelzellenmessung gemäß einer ersten bevorzugten Ausführungsform;

Figur 2 ein Schaltbild eines Details einer Anordnung zur Einzelzellenmessung gemäß einer zweiten bevorzugten Ausführungsform; und

Figur 3 ein Elektrogerät mit einer bekannten Anordnung zur Einzelzellenmessung.

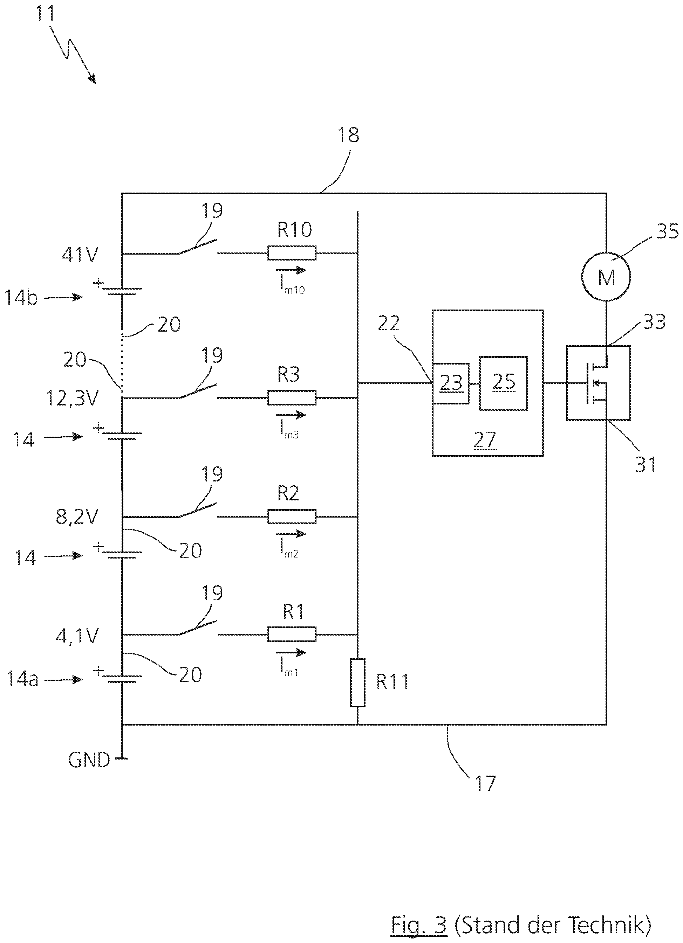

Das in Figur 3 gezeigte bekannte Elektrogerät 11 weist als Energiequelle eine Serienschaltung 13 aus mehreren Zellen 14 auf. Im gezeigten Beispiel sind zehn in Serie geschaltete Zellen 14 vorgesehen. Die Anzahl der Zellen 14 kann jedoch bei Bedarf variiert werden. Eine erste äußere Zelle 14a, die in Figur 3 unten dargestellt ist, ist mit ihrem Minuspol mit einer Masseleitung 17 des Elektrogeräts 11 verbunden. Eine zweite äußere Zelle 14b der Serienschaltung 13 ist mit ihrem Pluspol mit einer Versorgungsspannungsleitung 18 des Elektrogeräts 11 verbunden. Die einzelnen Zellen 14, 14a, 14b sind mittels Verbindungszweige 20 miteinander verbunden, wobei jeweils ein Verbindungszweig 20 den Plus-Pol einer Zelle 14, 14a mit dem Minus-Pol der jeweiligen benachbarten Zelle 14, 14b verbindet. Im gezeigten Beispiel handelt es sich bei den Zellen 14 um Lithiumionen-Akkuzellen, die eine Nennspannung von 4,1 V aufweisen, so dass die gesamte Serienschaltung 13 eine Nennspannung von 41 V aufweist. In Figur 3 ist das Potential an den einzelnen Plus-Polen der Zellen 14 bezogen auf ein mit GND bezeichnetes Massepotential an der Masseleitung 17 angegeben.

Der Pluspol einer jeden Zelle 14, 14a, 14b ist über ein gesondertes Schaltelement 19 und einen gesonderten Widerstand R1, R2, R3,..., R10 mit einem gemeinsamen Messleiter 21 verbunden. Der Messleiter 21 ist außerdem über einen Widerstand R11 mit der Masseleitung 17 verbunden. Ferner ist der Messleiter 21 an einen Messeingang 22 eines Analog-Digital-Wandlers 23 eines Steuergeräts 27 des Elektrogeräts 11 angeschlossen. Ein Ausgang des Analog-Digital-Wandlers 23 ist mit einem Eingang eines Mikrocontrollers 25 des Steuergeräts 27 verbunden. Das Steuergerät 27 ist so ausgebildet, dass der Mikrocontroller 25 die einzelnen Schaltelemente 19 aktivieren bzw. deaktivieren kann, so dass die entsprechenden Pluspole der einzelnen Zellen 14, 14a, 14b wahlweise über die entsprechenden Widerstände R1, R2, R3, ..., R10 mit dem Messleiter 21 elektrisch verbunden sind bzw. von dem Messleiter 21 elektrisch getrennt sind. Die Schaltelemente 19 gehören somit zu einer Schalteinrichtung zum wahlweisen Verbinden genau eines Verbindungszweigs 20 mit dem Messeingang 22.

Ein Ausgang des Steuergeräts 27 ist mit einem Steuereingang einer Leistungsendstufe 29 des Elektrogeräts 11 derart verbunden, dass der Mikrocontroller 25 die Leistungsendstufe 29 ansteuern kann. Die Leistungsendstufe 29 weist einen als ein Halbleiterschalter, beispielsweise als ein MOSFET, ausgebildetes Leistungsschaltelement auf. Ein erster Anschluss 31 der Leistungsendstufe 29 ist mit der Masseleitung 17 verbunden. Zwischen der Versorgungsspannungsleitung 18 und einem zweiten Anschluss 33 der Leistungsendstufe 29 ist ein Verbraucher des Elektrogeräts 11, beispielsweise ein Elektromotor 35 angeordnet, sodass der Verbraucher, das heißt der Elektromotor 35, mittels des Leistungsschaltelement entweder mit der Serienschaltung 13 verbunden werden kann oder von dieser getrennt werden kann.

Beim Betrieb des Elektrogeräts 11 überprüft das Steuergerät 27 regelmäßig den Zustand der einzelnen Zellen 14, 14a, 14b, indem es die Schaltelemente 19 so ansteuert, dass sie einzeln nacheinander aktiviert sind, das heißt die Pluspole der einzelnen Zellen 14, 14a, 14b werden nacheinander über die entsprechenden Widerstände R1, R2, R3, ..., R10 mit dem Messleiter 21 verbunden. Der mit dem aktivierten Schaltelement 19 verbundene Widerstand R1, R2, R3, ..., R10 sowie der Widerstand R11 bilden einen Spannungsteiler, dessen Mittelabgriff mit dem Messeingang 22 des Analog-Digital-Wandlers 23 verbunden ist. Eine vom Analog-Digital-Wandler 23 erfasste Spannung bezogen auf die Masseleitung 17 charakterisiert somit das Potential am Plus-Pol der jeweiligen Zelle 14, 14a, 14b. Der Mikrocontroller 25 ermittelt also anhand der mittels des Analog-Digital-Wandlers 23 erfassten Messwerte die Potentiale an den Plus-Polen der Zellen 14, 14a, 14b und berechnet hieraus die Spannungen an den einzelnen Zellen 14, 14a, 14b durch Subtraktion der Potentiale an den Pluspolen benachbarter Zellen 14, 14a, 14b. Das Potential am Pluspol der ersten äußeren Zelle 14a entspricht deren Zellspannung, sodass die genannte Subtraktion zur Berechnung dieser Zellspannung nicht erforderlich ist.

Im Einzelnen führt das Steuergerät 27 in regelmäßigen Abständen, vorzugsweise periodisch, Messzyklen zur Überprüfung der einzelnen Zellen 14, 14a, 14b aus. In jedem Messzyklus aktiviert das Steuergerät 27 zunächst das an den Widerstand R1 angeschlossene Schaltelement 19, um das Potential am Pluspol der in Figur 3 unten eingezeichneten ersten äußeren Zelle 14a zu erfassen. Anschließend öffnet es das genannte Schaltelement 19 wieder und schließt dasjenige Schaltelement 19, das an den Pluspol der benachbarten Zelle 14 angeschlossen ist und das im betrachteten Messzyklus noch nicht aktiviert worden ist. Die Schaltelemente 19 werden also reihum nacheinander aktiviert.

Hierdurch ergeben sich im Laufe des Messzyklus nacheinander die Messströme $I_{m1}$, $I_{m2}$, $I_{m3}$, ...,$I_{m10}$, die durch den jeweiligen Widerstand R1, ..., R10 fließen. Da jedes Schaltelement 19 im Laufe eines Messzyklus genau einmal aktiviert wird, fließt durch die in Figur 3 unten eingezeichnete Zelle 14a zehnmal der Messstrom $I_{m1}$, ...,$I_{m10}$, wohingegen durch die in Figur 3 oben dargestellte Zelle 14b lediglich einmal der Messstrom $I_{m10}$ fließt. Hierdurch wird durch die Messungen während eines Messzyklus beispielsweise der Zelle 14a deutlich mehr Ladung entnommen als etwa der Zelle 14b, so dass es zu Abweichungen im Ladezustand der einzelnen Zellen 14, 14a, 14b kommt. In anderen Worten, es besteht die Gefahr einer Debalanzierung des Ladezustands der einzelnen Zellen 14, 14a, 14b der Serienschaltung 13. Die Gefahr der Debalanzierung besteht insbesondere dann, wenn die Zellen 14, 14a, 14b der Serienschaltung 13 nicht oder nur geringfügig geladen oder entladen werden, das heißt wenn das Elektrogerät 11 längere Zeit nicht betrieben wird aber die Zellen dennoch überwacht werden.

Sind die Widerstände R1 bis R10 so dimensioniert, dass die Messströme $I_{m1}$ bis $I_{m10}$ zumindest im Wesentlichen die gleiche Höhe aufweisen, $I_{mess} = I_{m1} = ... = I_{m10}$ dann ergibt sich für die Ladung, die der Zelle i = 1,..., 10 während eines Messzyklus entnommen wird

$$Q_i = (11-i) \ast t_{mess} \ast I_{mess},$$

wobei die Zeit $t_{mess}$ einer Messdauer entspricht, dass heißt der Zeit, solange eines der Schaltelemente 19 aktiviert ist. Der Messstrom $I_{mess}$ entspricht dem Strom, der durch das jeweilige Schaltelement 19 fließt. Ein Strom durch eine bestimmte Zelle i beträgt folglich im Mittel

$$I_{mean,i} = Q_i/T,$$

wobei das Intervall T, die Dauer eines Gesamtmesszyklus bezeichnet. In den beiden oben angegebenen Gleichungen bezeichnet der Index i die einzelne Zelle 14, 14a, 14b. Hierbei entspricht der Index i = 1 der in Figur 3 unten eingezeichneten ersten äußeren Zelle 14a und der Index i = 10 der in Figur 3 oben eingezeichneten zweiten äußeren Zelle 14b. Die weiteren Indizes i = 2,..., 9 bezeichnen die zwischen den Zellen 14a, 14b liegenden Zellen 14 und zwar in der Reihenfolge von unten nach oben (bezogen auf die Darstellung in Figur 3).

Geht man von einem Messstrom $I_{mess} = I_{m1} = ... = I_{m10} = 0,41$ mA und einer Messdauer von $t_{mess} = 1$ ms aus, dann wird in einem Messzyklus der ersten äußeren Zelle 14a (i = 1) eine Ladung von $Q_1 = 4,1$ μAs entnommen, wohingegen der zweiten äußeren Zelle 14b (i = 10) lediglich eine Ladung von $Q_{10} = 0,41$ μAs entnommen wird. Wird der Messzyklus pro Sekunde einmal durchgeführt, dann wird der ersten äußeren Zelle 14a pro Tag infolge der Messungen eine Ladung von 354,24 mAs und der zweiten äußeren Zelle 14b ein Ladung von 35,42 mAs entnommen.

Werden die Messzyklen periodisch einmal pro Sekunde durchgeführt, kommt es zu einer ungleichmäßigen Entladung der einzelnen Zellen, was zu einer Debalanzierung des Ladezustands der einzelnen Zellen 14, 14a, 14b führen kann.

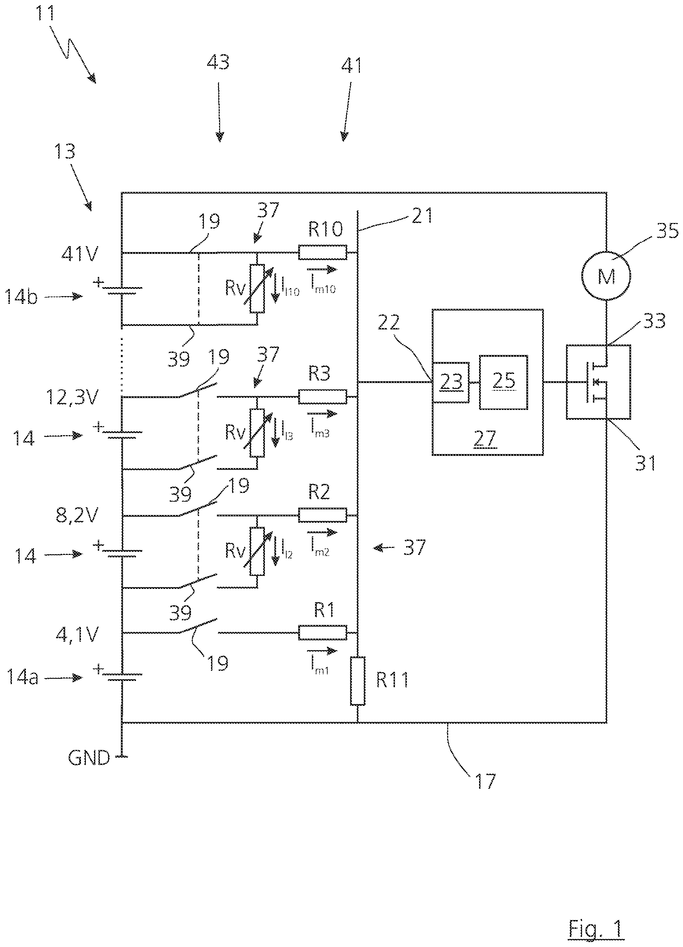

Figur 1 zeigt das Prinzipschaltbild eines Elektrogeräts 11, beispielsweise eines Elektrowerkzeugs, bei dem die ungleichmäßige Entladung der Akkuzellen 14, 14a, 14b zumindest weitgehend vermieden wird. In der Darstellung der Figur 1 werden für gleiche Elemente dieselben Bezugszeichen verwendet wie in Figur 3, und deshalb werden diese Elemente nicht nochmals im Detail erläutert. Anders als bei dem in Figur 3 dargestellten bekannten Elektrogerät 11 ist bei dem in Figur 1 dargestellten Elektrogerät 11 jeder Zelle 14, 14b mit Ausnahme der ersten Zelle 14a jeweils eine Last 37 zugeordnet, die das Steuergerät 27 wahlweise aktivieren und deaktivieren kann. Die Last 37 ist an zwei benachbarten Verbindungszweigen 20 angeschlossen, das heißt parallel zu der entsprechenden Zelle 14, 14b angeordnet. Jede Last 37, ist also zwischen dem Minus-Pol der entsprechenden Zelle 14, 14b sowie einem Verbindungspunkt zwischen dem Schaltelementen 19 und dem jeweiligen Widerstand R1 und R2, ..., R10 angeordnet.

Jede Last 37 weist ein weiteres Schaltelement 39 und einen mit diesem in Serie geschalteten Lastwiderstand $R_v$ auf. Das Elektrogerät 11 ist so eingerichtet, dass genau dann, wenn ein bestimmtes Schaltelement 19 aktiviert ist auch das derselben Zelle 14, 14b zugeordnete weitere Schaltelement 39 aktiviert ist. Das Steuergerät 27 aktiviert beziehungsweise deaktiviert die Schaltelemente 19, 39 also und zumindest im Wesentlichen gleichzeitig.

Die Elemente 19, R1, ..., R10, $R_v$, 39, 21, R11 und 27 bilden eine Anordnung 41 zum Überprüfen der einzelnen Zellen 14a, 14, 14b, beispielsweise durch Messen von Spannungen an den einzelnen Zellen 14a, 14, 14b. Bei dieser Anordnung 41 bewirken die Lasten 37, dass an allen Zellen 14, 14b außer der ersten Zelle 14a zusätzlich zu dem eigentlichen Messstrom $I_{mess} = I_{m1}$, $I_{m10}$ ein zusätzlicher Strom $I_{l2}$, ..., $I_{l10}$ fließt, sodass die einzelnen Zellen 14a, 14, 14b während eines Messzyklus gleichmäßig entladen werden. Der Wert der einzelnen Widerstände $R_v$ ist so bemessen, dass in einem Messzyklus jeder Zelle 14a, 14, 14b zumindest im Wesentlichen dieselbe Ladung $Q_i$, i = 1, ..., 10 entnommen wird.

Bei den Lastwiderständen $R_v$ kann es sich beispielsweise um einstellbare Widerstände handeln, die vor der ersten Inbetriebnahme des Elektrogeräts 11 abgeglichen werden. Alternativ hierzu können als Lastwiderstände $R_v$ auch entsprechend dimensionierte Festwiderstände vorgesehen werden.

Um eine gleichmäßige Entladung der einzelnen Zellen 14, 14a, 14b durch die Messzyklen zu erreichen, muss die zweite äußere Zelle 14b mit einem relativ großen zusätzlichen Strom $II_{10}$ belastet werden, wohingegen die ersten äußeren Zelle 14a nicht mit einem zusätzlichen Strom belastet werden muss. In der Reihenfolge der Zellen 14, 14, 14b in der Serienschaltung 13 beginnend mit der zweiten Zelle (i = 2) müssen die zusätzlichen Ströme also zunehmende Werte aufweisen, das heißt $I_{l2} < ... < I_{l10}$. Dementsprechend müssen die Werte der Lastwiderstände $R_v$ entsprechend abnehmende Werte haben.

Es kann vorgesehen werden, dass die Anordnung 41 Teil eines Akkupacks 43 ist, der außer der Anordnung 41 die Serienschaltung 13 der Zellen 14a, 14, 14b enthält. In den Akkupack 43 kann außerdem das Steuergerät 27 mit dem Analog-Digital-Wandler 23 und dem Mikrokontroller 25 integriert sein. In diesem Fall kann im Elektrogerät 11 aber außerhalb des Akkupacks 43 ein weiteres Steuergerät (nicht gezeigt) zum Ansteuern der Leistungsendstufe 29 vorhanden sein.

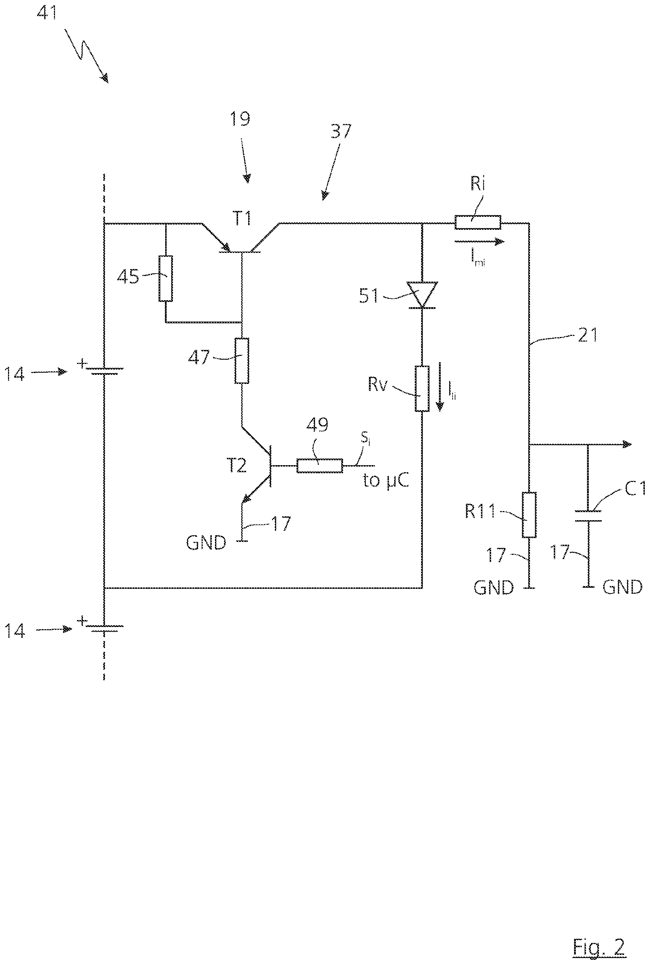

Figur 2 zeigt ein Schaltbild eines Details der Anordnung 41 zur Einzelzellenmessung gemäß einer weiteren Ausführungsform. Das Schaltelement 19 ist als Halbleiterschaltelement mit Bipolartransistoren T1 und T2 ausgebildet. Der PNP-Transistor T1 ist mit seinem Emitter an dem Plus-Pol der entsprechenden Zelle 14 angeschlossen. Ein Kollektor dieses Transistors T1 ist über den Widerstand R2, ....., R10 mit dem Messleiter 21 verbunden. Zwischen Basis und Emitter des Transistors T1 ist ein Basis-Emitter-Widerstand 45 angeordnet. Außerdem ist die Basis des Transistors T1 über einen Basiswiderstand 47 an den Kollektor eines als NPN-Transistor ausgebildeten Ansteuertransistors T2 angeschlossen. Ein Emitter-Anschluss des Ansteuertransistors T2 ist mit der Masseleitung 17 verbunden.

Die Basis des Ansteuertransistors T2 ist über einen Vorwiderstand 49 an einen Digitalausgang des Mikrocontrollers 25 angeschlossen. Jeder Zelle 14, 14b mit Ausnahme der ersten äußeren Zelle 14a ist jeweils in Schaltelement in Form des Transistors T1 und die dazugehörige Ansteuerschaltung in Form des Transistors T2 und der Widerstände 45, 47, 49 zugeordnet. Dementsprechend weist der Mikrocontroller 25 für jeden Ansteuertransistor T2 je einen Digitalausgang auf, der mit dem Vorwiderstand 49 genau eines Transistors T2 verbunden ist, sodass der Mikrocontroller 25 die Transistoren T2 getrennt voneinander ansteuern kann.

Die Last 37 weist in der in Figur 2 gezeigten Ausführungsform weist eine Serienschaltung aus einer Halbleiterdiode 51 und dem Lastwiderstand $R_v$ auf. Der Transistor T1 dient nicht nur zum Verbinden in Figur 2 oben dargestellten Verbindungszweigs 20 mit dem Messleiter 21 sondern auch zum Aktivieren und Deaktivieren der Last 37. Das heißt, der Transistor T1 bildet nicht nur das Schaltelement 19 der Schalteinrichtung, sondern ist zugleich ein Schaltelement der aktivierbaren und deaktivierbaren Last 37.

Entsprechend der in Figur 1 gezeigten Ausführungsform ist vorgesehen, dass lediglich den Zellen 14, 14b und nicht der ersten äußeren Zelle 14a die Last 37 zugeordnet ist. Ferner ist in der in Figur 2 gezeigten Ausführungsform zu dem Widerstand R11 ein Dämpfungskondensator C1 parallel geschaltet.

Beim Betrieb der Anordnung 41 steuert der Mikrokontroller 25 nacheinander über die Digitalausgänge die einzelnen Ansteuertransistoren T2 an, so dass diese und die entsprechenden Transistoren T1 durchschalten und sich ein entsprechender Messstrom $I_{m1}$, ..., $I_{m10}$ einstellt, zu dem gegebenenfalls der zusätzlicher Strom $I_{l2}$, ..., $I_{l10}$ durch die Last 37 hinzukommt. Hierbei gibt der Mikrocontroller 25 über die Digitalausgänge jeweils ein Steuersignal $s_i$, i = 1, ..., 10 aus, mittels dessen der jeweilige Ansteuertransistor T2 angesteuert wird. Bei dem Steuersignal $s_i$ handelt es sich um ein digitales Signal, das zwei stabile Zustände aufweisen kann, nämlich einen niedrigen Pegel (Low) und einen hohen Pegel (High). Das Schaltelement 19 ist genau dann aktiviert, wenn das Steuersignal $s_i$ den hohen Pegel aufweist.

Die Widerstände R1, ..., R10, R11 sind vorzugsweise so ausgelegt, dass sich am Messeingang 22 ein Potential einstellt, das nicht höher ist als das Potential an dem Pluspol der zweiten Zelle 14 - das heißt an derjenigen Zelle 14, die der ersten äußeren Zelle 14a benachbart ist - zuzüglich einer Durchlassspannung derjenigen Diode 51, die der zweiten Zelle 14 zugeordnet ist. Hierdurch werden Querströme zwischen den Pluspolen der einzelnen Zellen 14, 14b vermieden. In einer bevorzugten Ausführungsform sind die Widerstände R1, ..., R10, R11 so dimensioniert, dass das Potential am Messeingang 22 bezogen auf das Massepotential GND etwa 0 V bis 5V beträgt.

Insgesamt stellt die vorliegende Erfindung die Anordnung 41 zur Einzelzellenmessung beziehungsweise den Akkupack 43 bereit, bei dem durch die Messungen an den einzelnen Zellen 14a, 14, 14b ein ungleichmäßiges Entladen und somit eine Debalanzierung des Ladezustands der einzelnen Zellen 14, 14a, 14b zumindest weitgehend vermieden wird. Hierdurch wird der zuverlässige Betrieb der einzelnen Zellen 14, 14a, 14b beziehungsweise des Akkupacks 43 insbesondere dann sichergestellt, wenn die Zellen 14, 14a, 14b über längere Zeit weder geladen noch entladen werden, sondern lediglich von der Anordnung 41 überwacht werden.

**Patentansprüche**

1. Anordnung (41) zur Zellenmessung in einem Akkupack (43), wobei der Akkupack (43) eine Serienschaltung (13) aus mehreren Zellen (14, 14a, 14b) umfasst, wobei zwei benachbarte Zellen (14, 14a, 14b) mittels eines Verbindungszweigs (20) elektrisch miteinander verbunden sind, wobei ein äußerer Pol der Serienschaltung (13) einen Bezugspunkt (17) bildet, und wobei die Anordnung (41) eine Messeinrichtung (27) aufweist und eine Schalteinrichtung (19) umfasst, die zum wahlweisen Verbinden genau eines Verbindungszweigs (20) mit einem Messeingang (22) der Messeinrichtung (27) eingerichtet ist, wobei zumindest zu denjenigen Zellen (14, 14b), die mittelbar mit dem Bezugspunkt (17) verbunden sind, die Anordnung (41) jeweils mindestens eine zur jeweiligen Zelle parallel geschaltete Last (37) aufweist und wobei die Last (37) mittels eines Steuersignals (s) wahlweise in einen aktivierten Betriebszustand oder in einen deaktivierten Betriebszustand gebracht werden kann, sodass mindestens einer Zelle (14, 14a, 14b) während des aktivierten Betriebszustands mittels der Last (37) elektrische Ladung entnehmbar ist, wobei die Last (37) eine Serienschaltung umfassend einen Halbleiterschalter (T1) und einen Widerstand ($R_v$) aufweist, **dadurch gekennzeichnet, dass** der Wert des Widerstandes ($R_v$) jeweils so bemessen ist, dass in einem Messzyklus jeder Zelle (14, 14a, 14b) im Wesentlichen dieselbe Ladung Qi entnommen wird.

2. Anordnung (41) nach Anspruch 1, wobei ausschließlich diejenigen Zellen (14, 14b), die mittelbar mit dem Bezugspunkt (17) verbunden sind jeweils mindestens eine parallel geschaltete Last (37) aufweisen.

3. Anordnung (41) nach Anspruch 1 oder 2, wobei mindestens eine Last (37) genau einer Zelle (14, 14a, 14b) parallel geschaltet ist.

4. Anordnung (41) nach einem der vorhergehenden Ansprüche, wobei die Messeinrichtung (37) zum Erfassen einer Spannung zwischen dem Messeingang (22) und dem Bezugspunkt (17) innerhalb der Serienschaltung (13) eingerichtet ist, wobei der Bezugspunkt (17) mit einem Anschluss der Messeinrichtung (37) elektrisch verbunden ist.

5. Anordnung (41) nach einem der vorhergehenden Ansprüche, wobei alle Zellen (14, 14a, 14b) des Akkupacks (43) zu der Serienschaltung (13) gehören und/oder ein äußerer Pol der Serienschaltung, vorzugsweise ein Minuspol einer äußeren Zelle (14a) der Serienschaltung, den Bezugspunkt (17) bilden.

6. Anordnung nach einem der vorhergehenden Ansprüche, wobei die Last (37) mindestens ein Schaltelement (19, 39) aufweist, das bei aktivierter Last (37) geschlossen und bei deaktivierter Last geöffnet ist, wobei eines dieser Schaltelemente (19) zugleich ein Schaltelement der Schalteinrichtung bildet.

7. Anordnung (41) nach Anspruch 1, wobei die Serienschaltung zusätzlich eine Halbleiterdiode (51) aufweist, die mit dem Widerstand ($R_v$) in Serie geschaltet ist.

8. Akkupack (43) mit einer Anordnung (41) zur Zellenmessung nach einem der Ansprüche 1 bis 7, wobei der Akkupack (43) eine Serienschaltung (13) aus mehreren Zellen (14, 14a, 14b) umfasst, wobei zwei benachbarte Zellen (14, 14a, 14b) mittels eines Verbindungszweigs (20) elektrisch miteinander verbunden sind, wobei ein äußerer Pol der Serienschaltung (13) einen Bezugspunkt (17) bildet.

**Claims**

1. An arrangement (41) for measuring a cell in a rechargeable battery pack (43), wherein the rechargeable battery pack (43) comprises a series circuit (13) composed of a plurality of cells (14,14a,14b), wherein two adjacent cells (14,14a,14b) are electrically connected to one another by means of a connecting branch (20), wherein an outer pole of the series circuit (13) forms a reference point (17), and wherein the arrangement (41) has a measuring device (27) and comprises a switching device (19), which is equipped to selectively connect exactly one connecting branch (20) to a measuring input (22) of the measuring device (27), wherein the arrangement (41) comprises at least on load (37) being connected in parallel to one of the respective cells (14,14b), which are indirectly connected with the reference point (17), and wherein the load (37) can selectively be brought into an activated operating state or into a deactivated operating state by means of a control signal (s) such that electric charge can be taken from at least one cell (14,14a,14b) during the activated operating state by means of the load (37), wherein the load (37) including a series circuit comprises a semiconductor switch ($T1$) and a resistance ($R_v$) **characterized in that** the amount of resistance ($R_v$) is calculated such that in one measuring cycle of each cell (14,14a,14b) essentially the same load Qi is discharged.

2. The arrangement (41) of claim 1, wherein only those cells (14,14b) being connected indirectly with the reference point (17) comprise each at least one load (37) being connected in parallel.

3. The arrangement (41) of claim 1 or 2, wherein at least on load (37) is connected in parallel with exactly one cell (14,14a,14b).

4. The arrangement (41) according to one of the preceding claims, wherein the measuring device (37) is equipped for measuring a voltage between the measuring input (22) and the reference point (17) within the series circuit (13), wherein the reference point (17) is electrically connected to a terminal of the measuring device (37).

5. The arrangement (41) according to one of the preceding claims, wherein all cells (14,14a,14b) of the rechargeable battery pack (43) belong to the series circuit (13) and/or an outer pole of the series circuit, preferably a minus pole of an outer cell (14a) of the series circuit, forms the reference point (17).

6. The arrangement (41) according to one of the preceding claims, wherein the load (37) has at least one switching element (19, 39) which is closed when the load (37) is activated and open when the load is deactivated, wherein one of those switching elements (19) simultaneously forms a switching element of the switching device.

7. The arrangement (41) of claim 1, wherein the series circuit in addition comprises a semiconductor diode (51) which is connected with the resistance ($R_v$) in series.

8. Rechargeable battery pack (43) with an arrangement (41) for measuring a cell according to one of claims 1 to 7, wherein the rechargeable battery pack (43) comprises a series circuit (13) composed of a plurality of cells (14,14a,14b), wherein two adjacent cells (14,14a,14b) are electrically connected to one another by means of a connecting branch (20), wherein an outer pole of the series circuit (13) forms a reference point (17).

**Revendications**

1. Dispositif (41) de mesure de cellules dans une batterie d'accumulateurs (43), dans lequel la batterie d'accumulateurs comporte une connexion en série (13) de plusieurs cellules (14, 14a, 14b), dans laquelle deux cellules voisines (14, 14a, 14b) sont connectées électriquement entre elles au moyen d'une branche d'assemblage (20), dans lequel un pôle extérieur de la connexion en série (13) forme un point de référence (17), et dans lequel le dispositif (41) constitue une installation de mesure (27) et comporte un dispositif de commande (19), qui, pour assurer une liaison sélective, comporte exactement une branche d'assemblage (20) installée avec une entrée de mesure (22) de l'installation de mesure (27), dans laquelle au moins pour lesdites cellules (14, 14b), qui sont indirectement liées au point de référence (17), le dispositif (41) comporte au moins une des charges (37) connectée en parallèle à une des lesdits cellules (14, 14b), et dans lequel la charge (37) peut être activée arbitrairement dans un état de fonctionnement ou dans un état de disfonctionnement par un signal de commande (s), de telle manière qu'au moins une cellule (14, 14a, 14b) est capable de recevoir une charge électrique pendant l'état de fonctionnement activé au moyen de la charge (37), dans lequel la charge (37) comporte une connexion en série comprenant une compteur de sécurité de semi-conducteur (T1) et une résistance (R$_v$), **caractérisé en ce que** la valeur de la résistance (R$_v$) est mesurée de telle manière que, dans un cycle de mesures de chaque cellule (14, 14a, 14b) sensiblement la même charge Qi est prélevée.

2. Dispositif (41) selon la revendication 1, dans lequel exclusivement les cellules (14, 14b) indirectement couplées avec le point de référence (17), sont en mesure de présenter au moins une charge connectée en parallèle (37).

3. Dispositif (41) selon la revendication 1 ou 2, dans lequel au moins une charge (37) est connectée en parallèle précisément à une cellule (14, 14a, 14b).

4. Dispositif (41) selon l'une des revendications précédentes, dans lequel l'installation de mesure (37) pour atteindre une tension comprise entre l'entrée de mesure (22) et le point de référence (17), installée à l'intérieur de la connexion en série (13), dans lequel le point de référence (17) est électriquement connecté avec l'installation de mesure (37).

5. Dispositif (41) selon l'une des revendications précédentes, dans lequel toutes les cellules (14, 14a, 14b) de la batterie d'accumulateurs (43), appartiennent à la connexion en série (13), et/ou un pôle extérieur de la connexion en série, de préférence un mini-pôle d'une cellule extérieure (14a) de la connexion en série, constitue le point de référence (17).

6. Dispositif (41) selon l'une des revendications précédentes, dans lequel la charge (37) comporte au moins un élément de raccordement (19, 39), qui est fermé lorsque la charge (37) est activée et ouverte lorsque la charge est désactivée, dans lequel un de ces éléments de raccordement (19) constitue simultanément un élément de connexion de l'installation de connexion.

7. Dispositif (41) selon la revendication 1, dans lequel la connexion en série comporte accessoirement une diode semi conductrice (51) qui est couplée en série avec la résistance (R$_v$).

8. Batterie d'accumulateurs (43) comportant un dispositif (41) pour la mesure de cellules, selon l'une des revendications 1 à 7, dans laquelle la batterie d'accumulateurs (43) comporte une connexion en série (13) de plusieurs cellules (14, 14a, 14b), dans laquelle deux cellules voisines (14, 14a, 14b) sont connectées électriquement entre elles par une branche d'assemblage (20), dans laquelle un pôle extérieur de la connexion en série (13) constitue un point de référence (17).

Fig. 1

Fig. 2

Fig. 3 (Stand der Technik)

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 1289096 A2
- DE 69837661 T2
- US 6169385 B1
- JP 2010008227 A